# EUROPÄISCHE PATENTSCHRIFT

(11) **EP 1 080 252 B1**
(45) Veröffentlichungstag und Bekanntmachung des Hinweises auf die Patenterteilung: **07.08.2002**
(21) Anmeldenummer: 99952102.4
(22) Anmeldetag: 14.05.1999
(51) Int. Cl.: C25D 1/00

(54) **VERFAHREN ZUR GALVANISCHEN VERKUPFERUNG VON SUBSTRATEN**
METHOD FOR ELECTRO COPPERPLATING SUBSTRATES
PROCEDE DE CUIVRAGE ELECTROLYTIQUE DE SUBSTRATS

(30) Priorität: 16.05.1998 DE 19822076
(43) Veröffentlichungstag der Anmeldung: 07.03.2001
(73) Patentinhaber: Blasberg Oberflächentechnik GmbH, 42699 Solingen (DE)
(72) Erfinder: HUPE, Jürgen, D-40764 Langenfeld (DE); KRONENBERG, Walter, D-51065 Köln (DE); BREITKREUZ, Eugen, Pa-Te-City, Taoyuan Hsien (TW); SCHMERGEL, Ulrich, D-42699 Solingen (DE)
(74) Vertreter: Werner, Hans-Karsten, Dr.Dipl.-Chem.
(86) Internationale Anmeldenummer: EP9903321
(87) Internationale Veröffentlichungsnummer: WO9960188

(56) Entgegenhaltungen:
- EP-A- 0 137 397
- DE-A- 4 001 960
- US-A- 5 186 811

## Beschreibung

Gegenstand der vorliegenden Erfindung ist ein Verfahren zur galvanischen Verkupferung von Substraten unter Verwendung von unlöslichen Anoden in sauren Kupferbädern sowie separater Zuführung der verbrauchten Kupferionen.

Der Einsatz unlöslicher Anoden vor allem in Horizontal-Durchlaufanlagen, zur Metallisierung von Leiterplatten, erfordert eine kontinuierliche Nachführung von Kupferionen in die Prozeßlösung von außerhalb, da die Auflösung von Kupferanoden im Prozeßelektrolyten entfällt. Parallel dazu müssen die organischen Elektrolytzusätze, die für die physikalischen Eigenschaften der abzuscheidenden Kupferschicht sowie deren Verteilung über das Werkstück verantwortlich sind, ebenso nachgeführt werden.

Gemäß DE-A-44 05 741 geschieht das dadurch, daß in einer separaten "Regenerierzelle" Metall aufgelöst wird. Um diesen Vorgang Im notwendigen Maße zu beschleunigen, werden Redoxsysteme zugesetzt. Dabei ist es einerseits problematisch, die notwendigen Mengen an Kupferionen in Lösung zu bringen und zum anderen, daß eine weitgehend unkontrollierte Veränderung der organischen Zusätze über die an der Anode ablaufenden Zerstörungsprozesse hinaus durch das Redoxsystem zusätzlich entsteht. Das erschwert es ungemein, eine reproduzierbare Abscheidungsqualität über längere Produktionszeiträume zu erzielen, da das organische Zusatzmittelsystem - bestehend aus mehreren verschiedenen organischen Compounds - sehr leicht außer Balance und Kontrolle geraten kann. Durch die Redoxvorgänge entstehen Nebenprodukte, die zusätzlich die Bad- bzw. Abscheidungscharakteristik verändern. Darüber hinaus bewirkt der oxidative Abbau die Notwendigkeit, größere Mengen Zusatzorganik in den Prozeßelektrolyten nachzuführen. Dies wiederum erhöht deutlich die Produktionskosten und gegebenenfalls muß durch entsprechende Reinigungsmaßnahmen, z.B. Filtration über Aktivkohle, gegengesteuert werden. Dies alles ist unwirtschaftlich und kontraproduktiv.

In der DE 195 39 865 wird ein Verfahren beschrieben, das ohne Verwendung solcher zusätzlicher Redoxsysteme auskommen soll. Dabei wird in einem separaten Regenerierraum mit Hilfe einer löslichen Anode die Metallionenzufuhr ermöglicht. Gleichzeitig wird eine Hilfskathode verwendet, die durch Wahl geeigneter Mittel frei von Metallabscheidung gehalten wird. Eine Weiterführung dieser Lösung sieht vor, daß die unlöslichen Anoden der elektrolytischen Zelle sich in einem Hilfsanolyten befinden, der vom Elektrolyten über Anionen-undurchlässige Diaphragmen abgetrennt ist. Als nachteilig ist hierbei anzusehen, daß die bei Produktionsalterung notwendigen Mengen an Metallionen nur schwer in ausreichender Menge aufgelöst werden können bzw. sehr große Volumina des Regenerierraums mit einer sehr großen Zahl von Anoden notwendig sind. Auch hierbei wird die doppelte Zerstörung der Prozeßorganik nicht vermieden.

Prinzipiell erscheint es wenig ökonomisch und umweltfreundlich zu sein, zwar mit unlöslichen Anoden zu arbeiten, aber im Bypass die Metallionen über die Auflösung von Metallanoden dem Prozeß wieder zuzuführen.

In der EP 0 667 923 wird ein Verfahren zur elektrolytischen Beschichtung von z.B. Stahl mit Kupfer unter Verwendung unlöslicher Anoden, z.B. Platin, Iridiumoxid beschichtet, aus einem Kupferpyrophosphat-Elektrolyten beschrieben. Die notwendige Nachführung der Kupferionen erfolgt hierbei durch Zugabe von Kupferhydroxid. Hlerbei ist zu beachten, daß der Pyrophosphat-Elektrolyt im alkalischen pH-Bereich betrieben wird, während z.B. für die Metallisierung von Leiterplatten schwefelsaure Elektrolyte bevorzugt werden.

Die Aufgabe der vorliegenden Erfindung war es nun, einen vorzugsweise schwefelsauren Kupferelektrolyten zu konzipieren, der für den Einsatz unlöslicher Anoden - vor allem auch in Durchlaufanlagen - für Gleichstrom und/oder Pulse Reverse Plating Abscheidung geeignet ist, ohne daß es zu einer starken Beeinträchtigung der Zusatzmittelorganik bzw. zu einem erhöhten Abbau dieser Organik bzw. der verstärkten Bildung von Nebenprodukten kommt. Ferner soll die Nachführung der Metallionen so erfolgen, daß zusätzlich störende Veränderungen der Prozeßorganik vermieden werden. Die Führung des gesamten Elektrolysesystems einschließlich Prozeßorganik und Kupferionenregeneration soll kostengünstig, rohstoffsparend und umweltfreundlich sein, ohne daß technische qualitative Nachteile in Kauf zu nehmen sind. Es soll weiterhin auf Diaphragmen und Hilfselektrolyte verzichtet werden.

Diese Aufgabe wird erfindungsgemäß dadurch gelöst, daß unter Verzicht von Diaphragmen und Hilfselektrolyten die Hauptmenge der Kupferionen direkt zugeführt wird in Form von Kupfercarbonat und/oder basischem Kupfercarbonat in einem separaten Tank, der zum Arbeitselektrolyten im Bypass geführt wird, wobei das freigesetzte gasförmige CO₂ in dem separaten Tank abgetrennt wird.

Vorzugsweise werden Kupferbäder verwendet, die als organische Komponente Polymere enthalten, die hergestellt sind durch Polymerisation von bifunktionellen Propanderivaten mit einem oder mehreren ungesättigten Alkoholen mit 3 bis 10 Kohlenstoffatomen und eine oder mehreren Doppelund/oder Dreifachbindungen.

Diese Bäder sind beispielsweise beschrieben in der EP-A-0 137 397. Diese schwefelsauren Elektrolyte enthalten im allgemeinen nur Komponenten, die während des Elektrolysevorgangs keine Abbauprodukte bilden und die Qualität des abgeschiedenen Niederschlags in keiner Weise negativ beeinflussen bzw. die Balance des Systems stören. Es hat sich gezeigt, daß gerade diese Zusatzmittel für den Einsatz in Durchlaufanlagen mit Inertanoden besonders geeignet sind.

Das Problem der Nachführung der galvanisch abgeschiedenen Kupferionen erfolgt erfindungsgemäß in Form der Zugabe von Kupfersalzen. Die Zugabe von Kupfer(II)sulfat oder auch reinem Kupfer(II)hydroxid verbietet sich aber, da im ersten Fall eine zu starke Anreicherung an Sulfationen im Elektrolyten nicht zu vermeiden wäre und im zweiten Fall Neutralisationsprozesse die Effizienz beeinträchtigen würden.

Es hat sich gezeigt, daß die Zugabe von Kupfer(II)carbonat und/oder basischem Kupfer(II)carbonat gegebenenfalls in Verbindung mit geringen Mengen anderer Kupfersalzen wie z.B. Kupfer(II)sulfat in das Elektrolysesystem zu guten Ergebnissen hinsichtlich der erfindungsgemäßen Aufgabe führt.

Da beim Auflösen von Kupfer(II)carbonat CO₂ gebildet wird und somit eine merkliche Gasentwicklung und Trübung der Lösung auftritt, werden Maßnahmen ergriffen, um den starken Einfluß der Gasbildung auf die elektrolytische Kupferabscheidung zu vermeiden.

Daher erfolgt die Auflösung der Kupfersalze in einem separaten Tank, der zum Arbeitselektrolyten im Bypass geführt wird.

Der Behälter ist dazu mit Rührwerk und Heizung ausgestattet, um den Lösungsprozeß möglichst schnell und damit wirtschaftlich zu gestalten. Die sehr gute Temperaturbeständigkeit des Zusatzmittels gemäß EP 0 137 397 bewirkt, daß während des Lösungsprozesses unter erhöhter Temperatur praktisch keine Verringerung der elektrochemischen Aktivität auftritt.

Es sind praktisch keine Sonderzugaben an Additiv erforderlich, die die Wirtschaftlichkeit des Verfahrens verschlechtern, wie es meist bei Elektrolyten mit mehreren Komponenten zu beobachten ist. Die Einspeisung in den Prozeßelektrolyten erfolgt vorzugsweise über ein Pumpensystem mit Filtrationseinheit. Auf diese Weise können Störungen des Elektrolyseprozesses völlig vermieden werden.

In einer weiteren bevorzugten Ausführungsform der Erfindung werden verbrauchte Kupferätzlösungen umweltfreundlich recycelt und durch Zugabe von z.B. Natriumcarbonat in Kupfercarbonat überführt. Üblicherweise enthalten solche Kupferätzlösungen Kupferionen und Mineralsäuren, zum Beispiel Salzsäure, Schwefelsäure usw., und gegebenenfalls Oxidationsmittel sowie stabilisierende Stoffe. Diese Ätzlösungen können jetzt gesammelt werden. Weiterhin können unter Lufteinblasung Anodenreste oder Leiterplattenabfälle in der Lösung zusätzlich aufgelöst werden. Die Lösungen werden beispielsweise über Aktivkohlefilter in einen zweiten Tank überführt. Anschließend wird diese Lösung mit z.B. Natronlauge, oder anderen geeigneten Alkali-Lösungen auf einen pH-Wert unterhalb des Ausfällungs-pH-Wertes von Cu(OH)₂ eingestellt. Durch diese Neutralisierung wird vermieden, daß unnötige große Mengen an CO₂ während der Reaktion von Säure mit Carbonat freiwerden. Die Absaugeinrichtung und -leistung kann reduziert werden und somit deutlich wirtschaftlicher arbeiten. Unter Zugabe von z.B. Na₂CO₃ unter kräftigem Rühren wird CuCO₃ gebildet, das aus der Lösung ausfällt. Die überstehende Lösung wird klar. Nach einer ausreichenden Reaktionszeit wird die überstehende Klarphase vorsichtig abfiltriert. Das CuCO₃ wird mit Wasser versetzt, gerührt und der Vorgang insgesamt wiederholt. Das zurückbleibende Kupfercarbonat wird getrocknet und kann erfindungsgemäß zur Nachführung der Kupferionen eingesetzt werden.

Die Arbeitsparameter für den schwefelsauren Kupferelektrolyten sind im allgemeinen wie folgt:

| | | vorzugsweise |
|---|---|---|
| Cu²⁺ | 15 bis 40 g/l | 20 bis 30 |
| H₂SO₄ | 150 bis 300 g/l | 200 bis 250 |
| Cl⁻ | 30 bis 100 mg/l | 60 bis 80 |
| Zusatzmittel * | 4 bis 10 ml/l | 4 bis 10 |
| Arbeitstemperatur | 20 bis 50°C | 25 bis 35 |

| | | |
|---|---|---|
| * Cuprostar LP-1 (Einkomponentenzusatz gemäß EP 0 137 397) | | |

Die genannten Parameter beziehen sich vor allem auf einen Betrieb im horizontalen Durchlauf. Dabei können alle Plater gemäß dem Stand der Technik eingesetzt werden.

Die nach dem erfindungsgemäßen Verfahren hergestellten Kupferniederschläge sind feinkristallin, seidig-matt, nahezu frei von inneren Spannungen, duktil und weisen eine hohe Zugfestigkeit auf. Sie sind glatt und damit frei von Rauhigkeiten oder Poren. Die branchenüblichen Qualitätstests (z.B. gemäß MIL SPEC 55 110) werden problemlos bestanden. Der Elektrolyt weist eine ausgezeichnete gleichmäßige Metallverteilung über der Fläche und ein sehr gutes Streuvermögen z.B. in den Bohrungen von Leiterplatten auf.

Das erfindungsgemäße Verfahren ist in dem nachfolgenden Beispiel näher erläutert.

### Beispiel

| Elektrolytansatz: | |
|---|---|
| H₂SO₄ | 192,5 g/l |
| Cu²⁺ | 20,0 g/l |
| Cl⁻ | 62 mg/l |
| Zusatzmittel (LP-1) | 6 ml/l |
| Temperatur | 35 ± 1°C |
| Mechanische Badbewegung Anoden | Pt-Streckmetal |
| Stromdichte | 2 A/dm² |

Nach einer Galvanoperiode von 150 min waren 8,9 g/l Kupfer abgeschieden.

| | |
|---|---|
| Analyse H₂SO₄ | 204 g/l |
| | |
| Zugabe von 15,5 g/l CuCO₃ x Cu(OH)₂ (= 8,9 g/l Cu²⁺) | |
| | |
| Analyse H₂SO₄ nach Zugabe | 189,7 g/l |

| Zweite Galvanoperiode: | |
|---|---|
| Abgeschiedenes Kupfer | 9,1 g/l |
| H₂SO₄-Analyse | 202 g/l |
| | |
| Zugabe von 15,8 g/l CuCO₃ x Cu(OH)₂ | |
| | |
| Analyse H₂SO₄ | 189 g/l |

Die Abscheidungsqualität aus dem Elektrolyten war in allen Fällen den technischen Anforderungen entsprechend.

Eine Weiterführung des Elektrolyten führte auch nach 20 Galvanoperioden nicht zu Problemen.

## Patentansprüche

1. Verfahren zur galvanischen Verkupferung von Substraten unter Verwendung von unlöslichen Anoden in sauren Kupferbädern sowie separater Zuführung der verbrauchten Kupferionen, **dadurch gekennzeichnet, daß** unter Verzicht von Diaphragmen und Hilfselektrolyten die Hauptmenge der Kupferionen direkt zugeführt wird in Form von Kupfercarbonat und/oder basischem Kupfercarbonat in einem separatem Tank, der zum Arbeitselektrolyten im Bypass geführt wird, wobei das freigesetzte gasförmige CO₂ in dem separaten Tank abgetrennt wird.

2. Verfahren gemäß Anspruch 1, **dadurch gekennzeichnet, daß** die Kupferbäder als organische Komponente Polymere enthalten, die hergestellt sind durch Polymerisation von bifunktionellen Propanderivaten mit einem oder mehreren ungesättigten Alkoholen mit 3 bis 10 Kohlenstoffatomen und einer oder mehreren Doppel- und/oder Dreifachbindungen.

3. Verfahren gemäß Anspruch 1 oder 2, **dadurch gekennzeichnet, daß** das Kupfercarbonat hergestellt wird durch Ausfällung aus Kupfersalzlösungen mit Hilfe von Natriumcarbonat.

4. Verfahren gemäß Anspruch 3, **dadurch gekennzeichnet, daß** die Kupfersalzlösung vor der Ausfällung mit Hilfe von Natronlauge neutralisiert wird auf einen pH-Wert unterhalb des Ausfällungs-pH-Wertes von Kupferhydroxid.

## Claims

1. A process for the copper plating of substrates using insoluble anodes in acidic copper baths with separate replenishing of consumed copper ions, **characterized in that** the major portion of the copper ions is directly supplied in the form of copper carbonate and/or basic copper carbonate, dispensing with diaphragms and auxiliary electrolytes, in a separate tank operated in a bypass mode with respect to the working electrolyte, the released gaseous CO₂ being separated off in said separate tank.

2. The process according to claim 1, **characterized in that** the organic components in said copper baths are polymers prepared by the polymerization of bifunctional propane derivatives with one or more unsaturated alcohols with 3 to 10 carbon atoms and one or more double and/or triple bonds.

3. The process according to claim 1 or 2, **characterized in that** said copper carbonate is prepared by precipitation from copper salt solutions using sodium carbonate.

4. The process according to claim 3, **characterized in that** said copper salt solutions are neutralized to a pH value below the precipitation pH of copper hydroxide using aqueous sodium hydroxide prior to said precipitation.

## Revendications

1. Procédé de cuivrage électrolytique de substrats utilisant des anodes insolubles dans des bains de cuivre acides et une admission séparée des ions de cuivre consommés, **caractérisé en ce que**, sans utiliser de diaphragmes ni d'électrolytes secondaires, la majeure partie des ions de cuivre est admise directement sous forme de carbonate de cuivre et/ou de carbonate de cuivre alcalin à partir d'un réservoir séparé alimentant l'électrolyte de travail par une ligne de bypass, le CO₂ gazeux libéré étant évacué dans le réservoir séparé.

2. Procédé selon la revendication 1, **caractérisé en ce que** les bains de cuivre contiennent en tant que composants organiques des polymères produits par polymérisation de dérivés de propane bifonctionnels avec un ou plusieurs alcools insaturés comportant de 3 à 10 atomes de carbone et une ou plusieurs doubles et/ou triples liaisons.

3. Procédé selon la revendication 1 ou 2, **caractérisé en ce que** le carbonate de cuivre est produit par précipitation effectuée à partir de solutions de sel de cuivre au moyen de carbonate de sodium.

4. Procédé selon la revendication 3, **caractérisé en ce que** la solution de sel de cuivre est neutralisée avant la précipitation à l'aide de lessive de soude à un pH inférieur au pH de précipitation de l'hydroxyde de cuivre.
